# EUROPEAN PATENT APPLICATION

(11) **EP 0 618 760 A1**
(43) Date of publication of application: **05.10.1994**
(21) Application number: 94302378.8
(22) Date of filing: 31.03.1994
(51) Int. Cl.: H05K 7/14, H05K 9/00

(54) **Clip for attaching a print circuit board**

(30) Priority: 01.04.1993 JP 16143/93
(71) Applicant: EMHART INC., Newark, Delaware 19711 (US)
(72) Inventor: Umezawa, Takashi, Kanagawa Ken (JP)
(74) Representative: Randall, John Walter

(57) **Abstract**

A clip for attaching a print circuit board to a chassis and electrically connecting the earthing portion of the PCB to the chassis, comprising a board engagement portion to be inserted in and engage with a mounting hole in a PCB and a chassis engagement portion to be inserted in and engage with a mounting hole of the chassis and a transverse contact member engagement hole between the two engagement portions formed so that a conductive contact member inserted in said engagement holes contacts both the board engagement portion and the chassis engagement portion so that the two contact portions are connected electrically.

## Description

The present invention relates to a clip for attaching a print circuit board (PCB) or the like to a support such as the chassis of a vehicle body or the like.

An example of such a clip for attaching a PCB to the chassis of a vehicle body is described in Japanese U.M. Publication No. 51-39095. This clip has two engagement portions, i.e., a chassis engagement portion to engage with a vehicle body or chassis, and a print circuit board (PCB) engagement portion. The clip is attached to the chassis by insertion of chassis engagement portion in a mounting hole provided in the chassis and the PCB engagement portion of the clip thus attached to the chassis is pressed into a mounting hole of a print circuit board, thereby attaching the print circuit board via the clip to the chassis. This clip may be used to attach PCBs to the chassis at predetermined intervals and the attachment is simple.

In general, an earthing portion of a print circuit board is connected to the chassis electrically. The same applies to mounting a PCB on a vehicle body. Conventionally, means for electric connection, in addition to the above-mentioned clip, is required to connect the earthing portion of the print circuit board to the chassis.

Accordingly, it is an object of the present invention to provide a clip for attaching a print circuit board or the like which is capable of attaching the earthing portion of the PCB to the chassis.

According to the present invention, there is provided a clip for attaching a print circuit board or the like to a vehicle chassis or body or the like; characterised in that the PCB clip comprises an elongated member having one end formed with a board engagement portion adapted to engage the board when inserted into a mounting hole in the board and the other end formed with a chassis engagement portion adapted to engage the chassis when inserted into a mounting hole in the chassis, and a contact member engagement hole extending orthogonally to the longitudinal direction is formed in the clip between the two engagement portions, the engagement hole being adapted to receive a conductive contact member of which part extends to the board engagement portion and part extends to the chassis engagement portion when fitted in the engagement hole. Preferably an engagement portion in a mid portion of the contact member locks in the engagement hole, part of the contact member coming in contact with the board while part of the contact member comes in contact with the chassis so that the two contact portions are connected electrically.

In order that the present invention be better understood, a preferred embodiment will now be described in greater detail by way of example with reference to the accompanying drawings in which:-
Figure 1 is a front view of a PCB clip according to the present invention;
Figure 2 is a bottom view of the clip of Figure 1;
Figure 3 is a left side view of the clip of Figure 1;
Figure 4 is a right side view of the clip of Figure 1;
Figure 5 is a sectional view taken along line V-V of Figure 1;
Figure 6 is a front view of a contact member;
Figure 7 is a right side view of the contact member of Figure 6;
Figure 8 is a front view showing a print circuit board attached to a chassis by the use of the clip of Figure 1;
Figure 9 is a sectional view taken along line IX-IX of Figure 8, and
Figure 10 illustrates the detachment of a print circuit board from the clip.

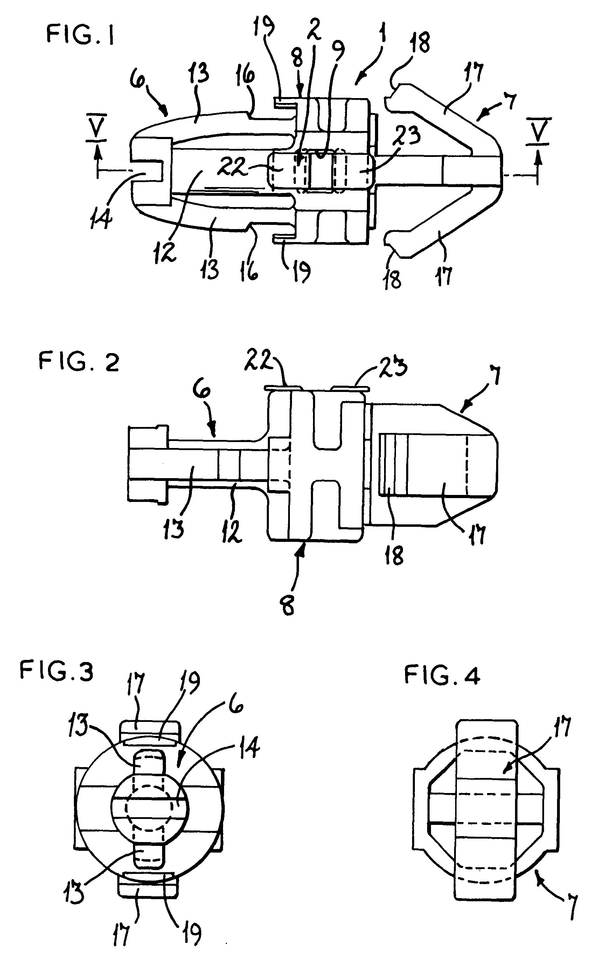

Referring to the drawings and in particular to Figures 1 to 5, clip (1) comprises a plastic member integrally moulded in an elongated stud-like form. On one end of the clip (1) a board engagement portion (6) is formed which is adapted to engage a print circuit board (PCB) (4) when it is inserted into a mounting hole of the board. At the other end of clip (1), a chassis engagement portion (7) is formed which is adapted to engage chassis (3) when engagement portion (7) is inserted into a mounting hole of the chassis. A substantially cylindrical base (8) is formed in a mid position between the two engagement portions (6,7), and from one side of the base a contact member engagement hole (9) is formed extending orthogonally to the longitudinal axis of the clip (1). The engagement hole (9) is adapted to receive a contact member (2) of which one part extends to the board engagement portion (6) and another part extends to the chassis engagement portion (7) when fitted into said hole (9) and an engagement element in a mid portion of contact member (2) is located in the engagement hole.

As seen from Figure 1, the board engagement portion (6) comprises a fulcrum (12) in the centre and a pair of flexible arms (13), extending from the end of the board engagement portion along the fulcrum (12) to the base (8). As shown in Figure 2, the fulcrum (12) and the arms (13) are flat and formed detachably from the print circuit board. As shown in Figure 3, on the end of the fulcrum (12), a groove (14) to engage with the end of a minus screw-driver is formed for rotating the clip (1). The chassis engagement portion (7) is formed with resilient anchor-like legs which are held firmly when inserted into the mounting hole of the chassis. The engagement portions (6,7) need not necessarily be in the configurations of the illustrated embodiment but may be in any shape as long as they can be attached to the print circuit board or the chassis. The base (8) functions as a flange to *a)* hold the print circuit board (4) in co-operation with engagement steps (16) formed in the arms (13) of the board engagement portion (6) and *b)* to be held by the chassis (3) by co-operation with engagement steps (18) of the anchor legs (17) of the chassis engagement portion (7) and also functions as a spacer to maintain a predetermined interval between the print circuit board and the chassis. For these purposes, the base (8) is formed like a cylinder of which the diameter is larger than that of the other portions. The configuration of the base (8) may also be varied as long as it functions as flanges and spacer as described above. Projections (19) extending to the engagement steps (16) are provided in positions corresponding to the engagement steps (16) of the arms (13) of the board engagement portion (6).

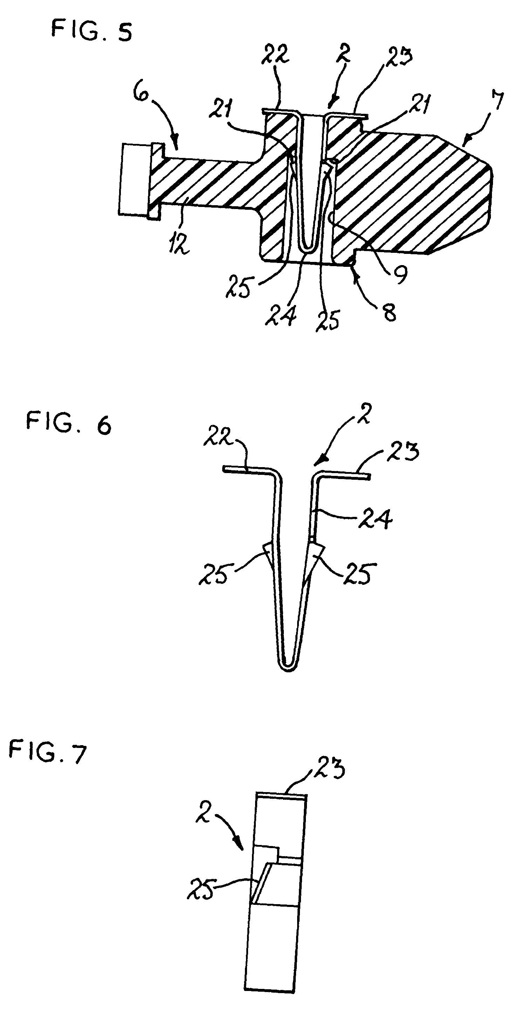

As described above, the base (8) is formed with a contact member engagement hole which penetrates it and extends orthogonally to the longitudinal direction of the clip (1). As shown in Figure 5, the contact member engagement hole (9) is formed with a smaller diameter upper portion and larger diameter lower portion to define an engagement step (21) where the diameter changes. The contact member (2) engages the engagement step (21).

Contact member (2) (Figures 6 and 7) comprises a thin plate made of conductive material and has a horizontal end element (22), another horizontal end element (23) and an engagement element (24) hanging orthogonally from a mid portion between the two portions. The engagement element (24) is V-shaped as illustrated and its mid portion is partially cut out to form a pair of engagement pawls (25). When the engagement pawls engage the engagement step (21) of the contact member engagement hole (9), the contact member (2) is thereby firmly attached to the base (8) of the clip. For this attachment, the contact member (2) preferably has resiliency like a spring so as to be inserted into the contact member engagement hole (9) easily and to maintain engagement force at a high level after the insertion. As shown in Figure 5, when the contact member (2) is attached to the base (8) of the clip (1), the horizontal end element (22) and the other horizontal end element (23) slightly project outwardly beyond the base (22).

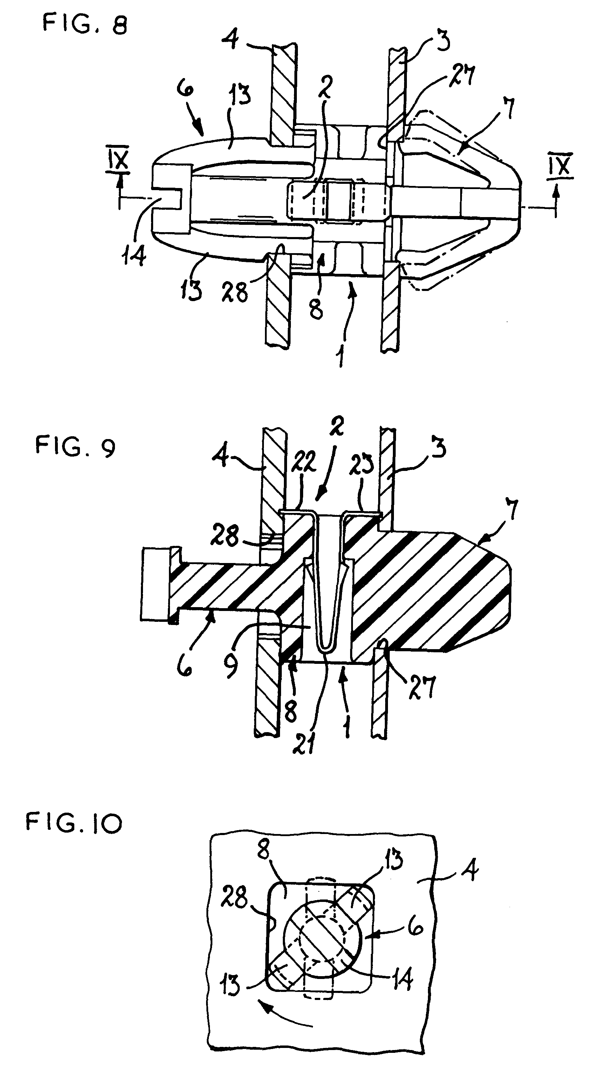

The attachment of the print circuit board (4) to the chassis (3) by means of the above-described clip (1) can be explained with reference to Figures 8 and 9. Initially the anchor legs of the chassis engagement portions (7) are inserted in a mounting hole (27) of the chassis (3) to attach the clip (1) to the chassis (3). The board engagement portion (6) of the clip is positioned to a mounting hole (28) of the print circuit board (4) and the board (4) in this state is pressed toward the chassis (3) whilst attached to the clip (1). Pressing brings the engagement steps (16) of the arms (13) into engagement with an edge of the print circuit board (4) to attach the board (4) to the clip (1), a space being left between them owing to base (8). This attachment brings the end of the end element (22) of the contact member (2) attached to the base (8) into contact with the print circuit board (4) and the end of the other end element (23) into contact with the chassis (3). The contact connects an earthing portion of the print circuit board (4) to the chassis (3) electrically. Where such electrical contact is not required, contact member may, of course, be omitted. As shown in Figure 10, if the end of a screw-driver is inserted in groove (14) formed on the end of the board engagement portion (6) and the latter is rotated as indicated by the arrow, the engagement steps of the arms (13) are lifted from the board (4) to allow it to be detached from clip (1).

Using the clip of the present invention, an end of an elongated member formed with a board engagement portion can be inserted in and engage a mounting hole of the board while the other end formed with a chassis engagement portion can be inserted in and engage a mounting hole of the chassis, a conductive contact member imay be inserted in the orthogonally extending engagement hole formed between the two engagement portions. Since the board and the chassis can be connected electrically through the conductive contact member of which one part extends to the board engagement member and an other part extends to the chassis engagement portion, conventionally needed wiring for the connection of an earth or the like becomes unnecessary.

## Claims

1. A clip for attaching a print circuit board or the like to a vehicle chassis or body or the like; characterised in that the PCB clip comprises an elongated member having one end formed with a board engagement portion adapted to engage the board when inserted into a mounting hole in the board and the other end formed with a chassis engagement portion adapted to engage the chassis when inserted into a mounting hole in the chassis, and a contact member engagement hole extending orthogonally to the longitudinal axis is formed in the clip between the two engagement portions; said engagement hole being adapted to receive a conductive contact member of which part extends to the board engagement portion and part extends to the chassis engagement portion when fitted in the engagement hole.

2. A PCB clip according to Claim 1, having a conductive contact member inserted in said engagement hole wherein an engagement portion in a mid portion of the contact member locks in the engagement hole, one part of the contact member coming in contact with the board while another part of the contact member comes in contact with the chassis so that the two contact portions are connected electrically.
